# DEMANDE DE BREVET EUROPEEN

(11) **EP 1 146 342 A2**
(43) Date de publication de la demande: **17.10.2001**
(21) Numéro de dépôt: 01400765.2
(22) Date de dépôt: 23.03.2001
(51) Int. Cl.: G01R 1/24

(54) **Module électronique hyperfréquences et procédé de test du module**

(30) Priorité: 31.03.2000 FR 0004133
(71) Demandeur: THOMSON CSF, 75008 Paris (FR)
(72) Inventeur: Douard, Marianne, Thomson-CSF Propriete Intell., 94117 Arcueil Cedex (FR); Giraudon, Jean-Claude, Thomson-CSF Propriete Intel, 94117 Arcueil Cedex (FR); Troussel, Michel, Thomson-CSF Propriete Intell., 94117 Arcueil Cedex (FR)
(74) Mandataire: Guérin, Michel

(57) **Abrégé**

L'invention concerne un module électronique (30) hyperfréquences et un procédé de test de ce module à au moins une fréquence de test Ft.

Le module électronique comporte sur un substrat (32), au moins une ligne (38) d'interconnexion électrique, d'impédance caractéristique Z0, entre deux composants (34, 36) du module, le substrat ayant sur la face comportant le conducteur électrique (46) de la ligne (38) d'interconnexion, de part et d'autre de ce conducteur électrique, des plages métalliques (52, 54, 56, 58) reliées à des conducteurs de masse.

Le procédé de test du module consiste court-circuiter la ligne (38) à la masse par les plages métalliques en un premier point de la ligne et à appliquer une sonde (60) de test d'impédance Z0 sur un second point de la ligne distant du court-circuit d'une longueur électrique sensiblement égal au quart d'onde λt/4 de la fréquence de test Ft. La sonde de test prélève un signal de test apparaissant à un accès (40) du composant (34) situé du coté de la sonde.

**Application** : test et dépannage de modules électroniques hyperfréquence.

## Description

L'invention concerne un module électronique hyperfréquences comportant des éléments intégrés permettant d'effectuer des tests des différentes fonctions du module. L'invention concerne aussi le procédé de test d'un tel module.

Un module électronique hyperfréquences est constitué essentiellement d'un substrat comportant des conducteurs électriques imprimés sur ses faces et des circuits intégrés reportés sur le substrat. Les circuits intégrés assurent les différentes fonctions du module électronique, à savoir, amplification, conversion, répartition etc., et comportent des entrées et des sorties ayant habituellement une impédance caractéristique Z0.

Les liaisons électriques entre les différentes fonctions des modules fonctionnant jusqu'au domaine millimétrique sont réalisées par des lignes adaptées de même impédance caractéristique Z0. Ces adaptations d'impédances entre les circuits sont nécessaires afin de diminuer les pertes en transmission et le taux d'ondes stationnaires sur les lignes.

La complexité croissante des modules électroniques hyperfréquences conduit à la réalisation d'assemblage de circuits intégrés avec un fort niveau d'intégration.

Les progrès réalisés sur les machines automatiques de câblage permettent la réalisation des modules complexe à très haut niveau d'intégration. La problématique du test de ces modules, notamment en terme de diagnostique de panne, n'en est pas pour autant éliminée mais au contraire devient plus difficile à résoudre.

Lorsque cela est possible, les fonctions d'un ensemble sont testées avant l'intégration de tous les composants dans un même procédé d'assemblage.

Pour les modules produits en grande quantité et à faible coût il n'est pas rentable d'effectuer un dépannage, ils sont simplement rebutés. Par contre pour les modules à forte valeur ajoutée, le diagnostique de panne et la réparation sont encore nécessaires, le coût d'une réparation étant alors relativement faible par rapport au coût du module.

Dans l'état de l'art, les modules électroniques hyperfréquences peuvent intégrer des éléments de test permettant de détecter la panne d'une ou plusieurs fonctions du module.

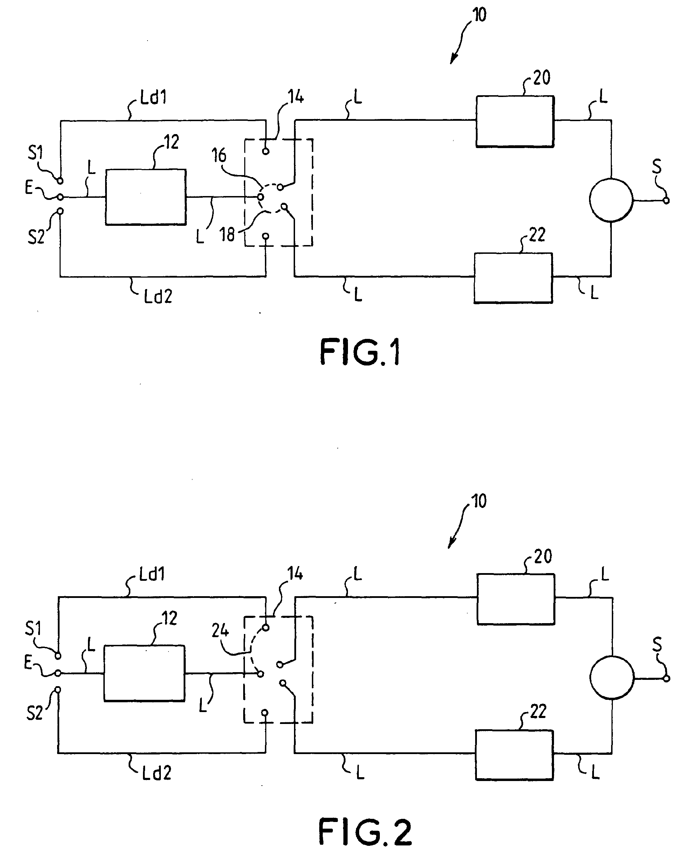

Dans une première technique de test, le module comporte des lignes et des sorties de test supplémentaires pour isoler le composant ou la fonction du module pouvant être défectueuse afin d'effectuer son test. Les figures 1 et 2 représentent le synoptique d'un module 10 électronique hyperfréquences de l'état de l'art utilisant cette technique.

Le module 10 comporte trois fonctions, une fonction d'entrée 12 en série, par l'intermédiaire d'un répartiteur 14 et deux connexions 16 et 18, avec deux fonctions de sortie 20 et 22 en parallèle. Ces fonctions sont reliées entre elles par des lignes L d'interconnexion électrique hyperfréquences d'impédance caractéristique Z0. Le substrat du module comporte deux lignes dérivées Ld1, Ld2, de même impédance caractéristique Z0, prévues à la conception du module pour effectuer les tests. Le module comporte une entrée E et une sortie S principale et deux sorties de test S1 et S2 reliées respectivement aux lignes dérivées Ld1 et Ld2.

Lorsqu'on souhaite effectuer le test de la fonction d'entrée 12, les connexions 16 et 18 (voir figure 1) reliant cette fonction aux fonctions de sortie sont dessoudées du substrat. La première ligne dérivée Ld1 est reliée par une de ses entrées à la sortie de la fonction d'entré 12 à tester à l'aide d'une connexion de test 24 soudée sur le substrat (voir figure 2). Un signal de test est alors appliqué sur l'entrée principale E. Le signal en sortie de la fonction d'entrée 12 est prélevé par une sonde à la sortie S1 de test de la ligne dérivée Ld1.

A la fin du test on dessoude la connexion 24 et on ressoude les connexions 16 et 18 afin de revenir à la configuration initiale du module.

Cette technique de test impose un accroissement de la dimension du module par l'implantation de lignes de test supplémentaires souvent incompatible avec les exigences du produit. De plus cette technique est restrictive dans le choix des fonctions à tester et ne peut être appliquée à toutes les fonctions du module.

Dans une autre technique de test, les entrées et sorties du circuit intégré ou de la fonction à tester sont décâblées de leur liaison électrique du substrat. Des pointes de test sont positionnées à l'aide d'une machine directement aux entrées et sorties du circuit intégré. Cette technique permet de réaliser des modules sans éléments de test intégrés sur le substrat. Néanmoins cette technique comporte des inconvénients importants. D'une part, compte tenu de la taille et la géométrie des points de test, certaines fonctions trop encaissées ou trop proches des parois d'un boîtier du module rendent le test impossible. D'autre part, le fait de décâbler puis recâbler les entrées et sorties du circuit intégré peut entraîner la dégradation voir la destruction du composant et notamment lorsqu'il s'agit de circuits intégrés fonctionnant en ondes millimétriques. De plus le fait d'isoler le circuit à tester de son ensemble ne permet pas de prendre en compte les effets des désadaptations dues à l'assemblage en terme de discontinuité (influence des connexions filaires) ou du report de masse. Ces derniers paramètres très importants dans les performances générales du module ne sont donc pas pris en compte en utilisant cette méthode.

Dans une autre technique, le test d'un composant ou d'une fonction du module électronique hyperfréquence, s'effectue par prélèvement d'énergie électromagnétique rayonnée par les connexions électriques entre les éléments à tester. Cette technique s'appuie sur l'effet de couplage électromagnétique entre une ligne de transmission du substrat et une sonde de test réalisée à cet effet. Cette technique n'est pas parfaitement maîtrisée et la sonde de test n'offre pas une bonne précision en terme de mesure hyperfréquences le signal pouvant être prélevé étant de niveau très faible et fortement perturbé.

L'invention est basée sur une technique de test hyperfréquences originale consistant à se servir des lignes d'interconnexion hyperfréquences, qui relient les différents composants ou fonctions du module, pour les transformer en cellules d'entrée/sortie conventionnelles d'impédance caractéristique Z0. A cet effet on prévoie, lors de la phase de conception du module, des métallisations de test imprimées sur le substrat. Ces métallisations permettent, moyennant un câblage supplémentaire lors du test, d'obtenir les cellules d'entrée/sortie. Cette technique utilise la propriété de propagation d'une onde hyperfréquences le long d'une ligne de transmission électrique et notamment le fait que l'impédance de la ligne à une distance quart d'onde d'un court circuit réalisé sur la ligne, est une forte impédance correspondant à un circuit ouvert. Ainsi, une pointe de test hyperfréquences, d'impédance caractéristique Z0, positionnée sur la ligne à cette distance quart d'onde du court-circuit, se comportera comme une charge adaptée pour le circuit à tester. En outre, la sonde ne sera pas perturbée par un signal sur la ligne provenant du côté du court-circuit.

A cet effet, afin de pallier les inconvénients de l'art antérieur, l'invention propose un module électronique hyperfréquences comportant :
- un substrat métallisé ayant deux faces principales, des conducteurs électriques imprimés sur ces faces et parmi ces conducteurs des conducteurs de masse reliés à une masse du module électronique ;
- des composants reportés sur le substrat ;
- au moins une ligne d'interconnexion électrique entre deux composants, la ligne d'interconnexion d'impédance caractéristique Z0 étant formée par un conducteur électrique et au moins un conducteur de masse, caractérisé en ce que le substrat comporte sur la face ayant le conducteur électrique de la ligne d'interconnexion, de part et d'autre de ce conducteur électrique, des plages métalliques reliées aux conducteurs de masse, ces plages métalliques étant destinées à effecteur un test électrique hyperfréquence, à au moins une fréquence de test Ft, des composants reliés par la ligne.

Il est à remarquer que pour effectuer un test à une fréquence Ft des fonctions reliées par une ligne d'interconnexion électrique, la longueur électrique de cette ligne devra être d'au moins un quart d'onde soit λt/4.

Dans la grande majorité des modules électroniques hyperfréquences, les ligne d'interconnexion électrique entre les circuits intégrés (ou les fonctions du module) sont des lignes d'interconnexion de type micro-bande d'impédance caractéristique Z0. Dans ce type de ligne, un premier conducteur électrique de la ligne, en forme de ruban métallique, est imprimé sur une des faces du substrat, un second conducteur de masse est imprimé sur l'autre face du substrat parallèle à la première, ce second conducteur de masse recouvrant le premier conducteur de la ligne. Dans cette configuration la quasi-totalité des lignes de champs électrique entre les deux conducteurs de la ligne traversent l'épaisseur du substrat.

Dans une première réalisation préférentielle du module électronique utilisant au moins une ligne micro-bande entre deux composants, le substrat comporte au moins deux paires de plages métalliques, chaque plage métallique d'une paire étant en vis-à-vis l'une de l'autre et de part et d'autre du conducteur électrique de la ligne d'interconnexion, les plages métalliques étant de dimensions, dans le plan du substrat, bien plus petites que la longueur de la ligne d'interconnexion.

L'invention propose aussi un procédé de test électrique d'un module électronique hyperfréquences, le test étant effectué à au moins une fréquence de test Ft, le module électronique comportant :
- un substrat métallisé ayant deux faces principales, des conducteurs électriques imprimés sur les faces et parmi ces conducteurs des conducteurs de masse reliés à une masse du module électronique ;
- des composants reportés sur le substrat ;
- au moins une ligne d'interconnexion électrique entre deux composants, la ligne d'interconnexion, d'impédance caractéristique Z0, étant formée par un conducteur électrique et au moins un conducteur de masse, le substrat comportant sur la face ayant le conducteur électrique de la ligne d'interconnexion, de part et d'autre de ce conducteur électrique, des plages métalliques reliées aux conducteurs de masse, caractérisé en ce qu'il comporte au moins les étapes suivantes :

- réalisation d'un court circuit en un premier point de la ligne entre un premier point du conducteur électrique de la ligne et les plages métalliques de masse ;
- application d'une sonde de test d'impédance caractéristique Z0 sur un second point de la ligne entre un second point du conducteur électrique et les plages de masse, ce second point étant distant du court-circuit (premier point) d'une longueur électrique sensiblement égale au quart d'onde λt/4 de la fréquence de test Ft ;
- application d'un signal hyperfréquence de test, à la fréquence de test Ft, à un accès d'un des composants à tester ;
- prélèvement par la sonde de test du signal de sortie apparaissant sur ce second point de la ligne.

L'invention n'est pas limitative. En effet le test peut être réalisé sur des modules complexes comportant plusieurs lignes et des nombreux composants interconnectés, le module étant conçu à l'origine avec des éléments de test, tels que définis dans l'invention, disposés sur certaines lignes de façon à effectuer le test de fonctions prédéterminées. De même, le composant peut être lui-même une fonction complexe constitué par des ensembles de circuits intégrés et des circuits passifs adaptés en impédance et connectés aux lignes adaptées d'interconnexion hyperfréquences de même impédance.

L'invention sera mieux comprise à l'aide d'exemples de réalisations de modules électroniques selon l'invention en référence aux dessins annexés, dans lesquels :
- les figures 1 et 2 représentent le synoptique d'un module électronique hyperfréquences de l'état de l'art ;
- la figure 3 montre une vue partielle d'un module électronique hyperfréquence selon l'invention ;
- les figures 4 et 5 montrent des vues en coupe du substrat du module de la figure 3 ;
- la figure 6 montre une vue simplifiée en coupe d'une sonde de test hyperfréquences ;
- la figure 7 représente une vue partielle du module de la figure 3 lors d'une première phase de la procédure de test.
- la figure 8 représente la vue partielle du module de la figure 3 lors d'une deuxième phase de la procédure de test.

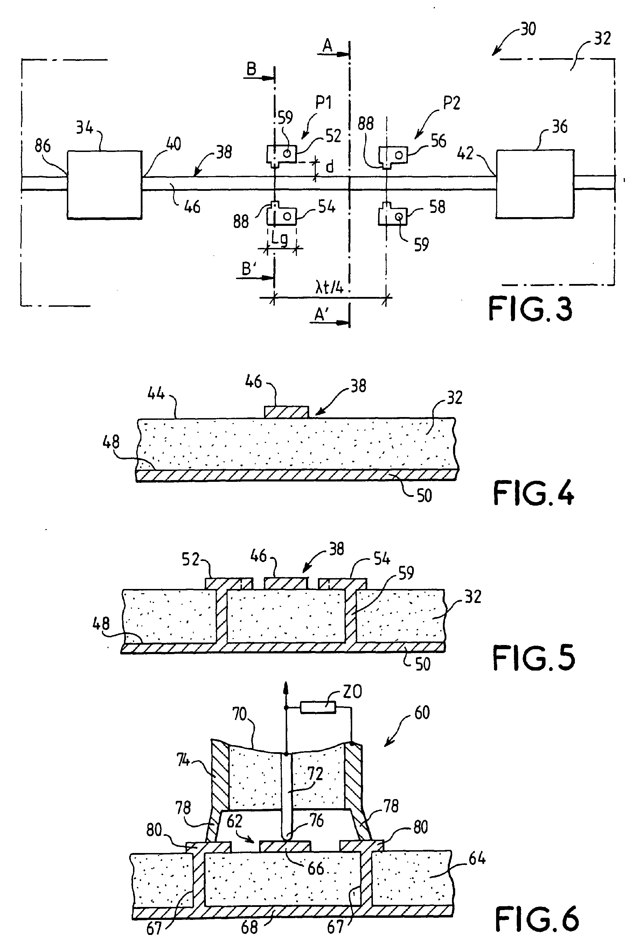

La figure 3 montre une vue partielle d'un module électronique hyperfréquence 30 selon l'invention, comportant des éléments de test à une fréquence Ft prédéterminée à la conception du module.

Le module 30 comporte un substrat 32 sur lequel sont reportés un premier circuit intégré 34 et un deuxième circuit intégré 36. Une ligne 38 d'interconnexion électrique hyperfréquences, d'impédance caractéristique Z0, relié une sortie de signal 40 du premier circuit intégré 34 à une entrée de signal 42 du deuxième circuit intégré 36. La longueur électrique de la ligne est au moins égale ou supérieure au quart de la longueur d'onde λt de la fréquence de test Ft de manière à pouvoir effectuer les tests selon la procédure de l'invention.

Dans cette réalisation la ligne d'interconnexion 38 hyperfréquences est de type micro-bande. La figure 4 montre une vue en coupe AA' du substrat 32 au niveau de la ligne 38 d'interconnexion. Le substrat 32 comporte deux faces métallisées une face avant 44 sur laquelle est imprimé un conducteur électrique 46 de la ligne 38 en forme de ruban métallique et une face arrière 48 comportant un conducteur de masse 50 recouvrant le conducteur 46 sur toute sa longueur. De façon connue, l'impédance caractéristique Z0 de la ligne 38 est déterminée à partir de l'épaisseur du substrat 32, de sa constante diélectrique et de la largeur du conducteur électrique de la ligne.

Le substrat 32 comporte deux paires P1, P2 de deux plages métalliques chacune, respectivement 52, 54 et 56, 58, les plages métalliques de chacune des paires étant situées de part et d'autre du conducteur 46 de la ligne 36 et en vis-à-vis l'une de l'autre, les plages métalliques étant de dimensions, dans le plan du substrat, bien plus petites que la longueur de la ligne d'interconnexion entre les deux circuits intégrés. La première paire P1 est située du coté de la première fonction 34 et la deuxième paire P2 du côté de la deuxième fonction 36 et à une distance électrique de la première paire P1 sensiblement égale au quart d'onde λt/4 de la fréquence de test Ft.

La figure 5 montre une vue en coupe BB' du substrat 32 au niveau de la première paire P1 des plages métalliques 52, 54. Les plages métalliques sont reliées au conducteur de masse 50 de la face 48 du substrat par des trous métallisés 59.

Le fort niveau d'intégration des modules hyperfréquences et leurs fréquences de travail élevées nécessitent pour leur test l'utilisation de sondes hyperfréquences de taille très petite. Ces sondes sont portées par un bras mécanique piloté par un opérateur afin de poser la sonde avec une grande précision sur le point de test du circuit.

La figure 6 montre une vue simplifiée en coupe d'une telle sonde 60 posée sur un point de test d'une ligne hyperfréquences 62, de type micro-bande, d'un module hyperfréquences à tester. La ligne 62 réalisée sur un substrat 64 comporte un conducteur électrique 66 sur une face du substrat et un conducteur de masse 68 sur l'autre face.

La sonde 60 coaxiale comporte un isolant 70 ayant une âme 72 coaxiale (point chaud) et un blindage 74. Lors du test, une pointe 76 de l'âme 72 de la sonde et deux languettes métalliques 78 entourant la partie libre de l'âme 72 sont mises respectivement en contact avec le conducteur électrique 66 de la ligne 62 et des plages métalliques 80 de masse situées sur la même face. Le report du conducteur de masse 68 de la ligne sur la face du substrat comportant le conducteur électrique 66 de la ligne s'effectuant par des trous métallisés 67.

La sonde est chargée par l'impédance caractéristique Z0. Ce type de sonde adaptée assure dans une procédure de test selon l'invention, une bonne adaptation de la fonction à tester.

Le test des deux fonctions 34 et 36 du module est effectué de la façon suivante:

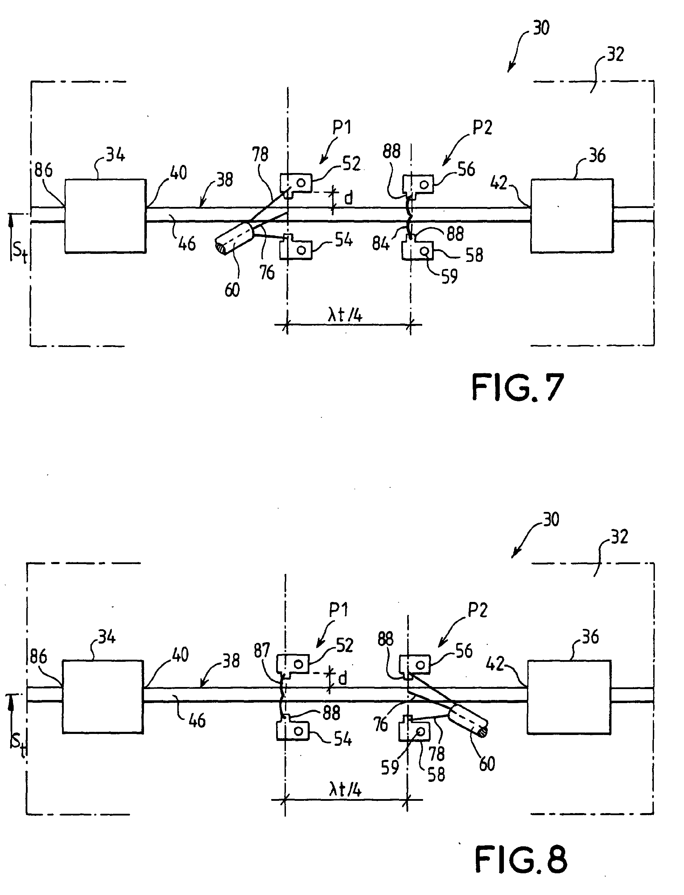

Dans une première phase on effectue le test du premier circuit intégré 34, à cet effet on réalise les opérations suivantes :
- mise en court-circuit à la masse de la ligne 38 (voir figure 7) au niveau de deuxième paire P2 en reliant, par soudure d'une connexion métallique 84, le conducteur électrique 46 et les plages métalliques 56, 58 de la seconde paire P2.
- application de la sonde de test 60 hyperfréquence sur la ligne 38 au niveau de la première paire P1 en appliquant la pointe 76 de la sonde 60 (point chaud) et ses languettes de masse 78 respectivement sur le conducteur électrique 46 et les plages métalliques 52, 54 de la première paire P1.
- injection d'un signal de test St à la fréquence de test Ft, à une entrée 86 de la première fonction 34, à l'aide d'une sonde d'injection (non représentée) semblable à la sonde 60.

Un signal de test apparaissant à la sortie 40 de cette première fonction 34 se propage sur la ligne 38. Comme cela a été dit précédemment, le court-circuit réalisé sur la ligne 38, au niveau de la deuxième paire P2 se traduit, à la fréquence de test Ft, par une forte impédance de la ligne au niveau de la première paire P1. La sortie 40 du premier circuit 34 se trouve chargée, à travers la ligne 38, sur l'impédance caractéristique Z0 de la sonde, ce qui permet d'effectuer le test du premier circuit intégré 32 sur une charge adaptée d'impédance Z0.

En outre le court-circuit de la ligne 38 au niveau de la deuxième paire P2 réduit toute perturbation sur la sonde de test 60 appliquée sur la ligne 38 par un signal en provenance de l'entrée 42 du deuxième circuit intégré 36.

L'analyse des signaux en sortie 40 prélevés par la sonde 60 permet d'établir l'état de ce premier circuit 34.

Le test du premier circuit 34 étant terminé, on retire les sondes et on dessoude la connexion 84 de court-circuit ramenant la ligne 38 et le module dans son état initial.

Dans une seconde phase on effectue le test du deuxième circuit intégré 36. Dans cette phase on prélève un signal émis par l'entrée du deuxième circuit intègré 36 à partir du signal St injecté à l'entrée 86 du premier circuit intégré 34. A cet effet on réalise les opérations suivantes:
- mise en court-circuit à la masse de la ligne 38 (voir figure8) au niveau de la première paire P1 en reliant, par soudure d'une connexion métallique 87, le conducteur électrique 46 et les plages métalliques 52, 54 de cette première paire P1.
- application de la sonde de test 60 hyperfréquence sur la ligne 38 au niveau de la deuxième paire P2 en appliquant la pointe 76 de la sonde (point chaud) et ses languettes de masse 78 respectivement sur le conducteur électrique 46 et les plages métalliques 56, 58 de la deuxième paire P2.
- injection d'un signal de test St à l'entrée 86 de la première fonction 34 à l'aide d'une sonde d'injection (non représentée) semblable à la sonde de test 60.

Un signal de test apparaissant à l'entrée 42 de la deuxième fonction 36 se propage sur la ligne 38. Le court-circuit réalisé sur la ligne 38, au niveau de la première paire P1 se traduit, à la fréquence de test Ft, par une forte impédance de la ligne au niveau de la deuxième paire P2. L'entrée 42 du deuxième circuit 36 se trouve chargée, à travers la ligne 38, sur l'impédance caractéristique Z0 de la sonde 60, ce qui permet d'effectuer le test du deuxième circuit intégré 36 sur une charge adaptée d'impédance Z0. En outre le court-circuit de la ligne 38 du côté du premier circuit 34, évite toute perturbation sur la sonde de test 60 par un signal en provenance de la sortie 40 de ce premier circuit intégré 34.

L'analyse des signaux à l'entrée 42 du deuxième circuit 36 permet d'établir un diagnostique d'état de ce circuit.

Les plages métalliques des deux paires P1 et P2, comportent des excroissances 88 (voir figures 3, 6 et 7) de très faible largeur par rapport aux dimensions des plages métalliques. Ces excroissances dirigées vers le conducteur électrique 46 de la ligne 38 rapprochent la masse métallique du conducteur électrique de la ligne permettant d'obtenir ainsi un court-circuit de très faible impédance lors de la soudure des connexions métalliques nécessaires au test. Ces excroissances évitent la réalisation des plages métalliques trop proches (distance d) du conducteur électrique 46 de la ligne 38 en réduisant l'effet de ligne coplanaire dû à la proximité des masses.

La distance entre les paires P1, P2 de plages métalliques est liée à la fréquence utilisée pour le test et conditionne la bande d'utilisation d'un tel dispositif, théoriquement applicable à une seule fréquence. Toutefois, le principe de test selon l'invention peut, en pratique, être utilisé sur une largeur de bande de 10% autour de la fréquence pour laquelle la distance quart d'onde a été calculée.

Dans un mode dégradé, un test, avec une adaptation légèrement inférieure de la cellule de charge (ligne et sonde) de la fonction à tester, peut être effectué dans une largeur de bande plus importante de l'ordre de 20% autour de la fréquence calculée.

Dans le cas de modules électroniques hyperfréquences fonctionnant en large bande, la mise en oeuvre du procédé de test selon l'invention permet de faire un diagnostique de panne à une fréquence particulière de la bande de spécification du produit, ce qui s'avère, dans la majorité des cas, suffisant pour déterminer le module ou la fonction en panne.

Un autre avantage de la procédure de test selon l'invention réside dans le fait que pour certains modules hyperfréquences déjà étudiés, il est possible d'ajouter aisément les deux paires des plages métalliques permettant d'utiliser cette procédure.

Dans une variante de la réalisation de la figure 3, le substrat du module électronique comporte une troisième paire P3 de plages métalliques ce qui permet d'effectuer le test selon l'invention sur une autre fréquence Ft'. La deuxième paire P2 est située à un premier quart d'onde λt/4 de la première paire P1, la troisième paire P3 étant située à un second quart d'onde λt'/4 de cette première paire P1, ce qui permet d'effectuer le test respectivement à la première fréquence de test Ft et à une deuxième fréquence de test Ft'. Pour cette variante, la procédure de test est la même que dans le cas du module comportant deux paires mais sera réalisée une première fois, à la fréquence Ft en utilisant la première et la deuxième paire et une seconde fois à la fréquence Ft' en utilisant la première et la troisième paire.

Dans une autre réalisation du module électronique selon l'invention, deux plages métalliques d'au moins une des deux paires sont allongées parallèlement au conducteur électrique de la ligne. Cette configuration, sous peine d'une faible perturbation de l'adaptation de la ligne due à la présence à proximité du conducteur électrique de la ligne, des plages métallisées de longueur plus importante, permet d'effecteur un test sur une plage de fréquences de test. Cette plage de fréquences correspondant à une plage de distances électriques possibles entre une première paire de longueur Lg très faible et les deux extrémités de la deuxième paire de plages métalliques de plus grande longueur. En effet dans cette autre réalisation si le court-circuit sur la ligne est effectué au niveau de la première paire, la sonde peut être placée en un point de la ligne situé en un point quelconque de la ligne situé entre les extrémités des plages métalliques de la deuxième paire. Si la sonde est placée au niveau de la première paire, le court-circuit peut être réalisé en point quelconque de la ligne situé entre les extrémités des plages métalliques de la deuxième paire.

Dans l'exemple de réalisation de la figure 3, le module électronique selon l'invention fonctionne à 10 GHz, le substrat présente une épaisseur de 0,38 millimètres et le conducteur électrique de la ligne d'interconnexion 38 une largeur de 380 micromètres. La distance d séparant les plages métalliques de la ligne est de l'ordre de 450 micromètres. Le quart de la longeur d'onde est de 2,9 millimètres.

Pour utiliser la cellule de test comme accès pour les deux circuits hyperfréquences à tester directement sur le module, il faut définir dès la phase de conception le mode opératoire permettant d'accéder aux cellules de test avec les sondes hyperfréquences. Le plus souvent les pointes standards avec un angle d'inclinaison par rapport au plan du substrat de 45 degrés permettent cet accès, dans certains cas des pointes verticales pourront être utilisées.

L'influence de la cellule de test (ligne et sonde) sur la fonction à tester est faible. En effet pour une bande de fréquences de test de 20% autour de la fréquence de calcul déterminant la distance entre paires de plages, la désadaptation du circuit de test est faible, le coefficient de réflexion étant supérieur à 20 dB et la variation des pertes inférieure à -0,05 dB.

## Revendications

1. Module électronique hyperfréquences comportant :
- un substrat (32) métallisé ayant deux faces principales (44, 48), des conducteurs électriques (46, 50, 66, 68) imprimés sur ces faces et parmi ces conducteurs des conducteurs de masse (50, 68) reliés à une masse du module électronique ;
- des composants (12, 20, 22, 34, 36) reportés sur le substrat ;
- au moins une ligne (L, 38) d'interconnexion électrique entre deux composants, la ligne d'interconnexion, d'impédance caractéristique Z0 étant formée par un conducteur électrique (46, 66) et au moins un conducteur de masse (50, 68), **caractérisé en ce que** le substrat (32) comporte sur la face (44) ayant le conducteur électrique (46) de la ligne (38) d'interconnexion, de part et d'autre de ce conducteur électrique, des plages métalliques (52, 54, 56, 58) reliées aux conducteurs de masse (50), ces plages métalliques étant destinées à effecteur un test électrique hyperfréquence, à au moins une fréquence de test Ft, des composants reliés par la ligne.

2. Module électronique selon la revendication 1, **caractérisé en ce que** la ligne d'interconnexion électrique (38) entre les deux circuits intégrés (34, 36) est une ligne micro-bande d'impédance caractéristique Z0, un premier conducteur électrique (46) de la ligne se trouvant sur une des faces (44) du substrat, le second conducteur de masse (50) se trouvant sur l'autre face (48) du substrat, parallèle au premier conducteur.

3. Module électronique selon la revendication 2, **caractérisé en ce que** le substrat comporte au moins deux paires P1, P2 de plages métalliques (52, 54, 56, 58), chaque plage métallique d'une paire étant en vis-à-vis l'une de l'autre et de part et d'autre du conducteur électrique (46) de la ligne (38) d'interconnexion, les plages métalliques étant de dimensions, dans le plan du substrat, bien plus petites que la longueur de la ligne d'interconnexion.

4. Module électronique selon la revendication 3, **caractérisé en ce que** les plages métalliques comportent des excroissances (88) de très faible largeur par rapport aux dimensions des plages métalliques, ces excroissances dirigées vers le conducteur électrique (46) de la ligne (38) rapprochant la masse métallique du conducteur électrique de la ligne.

5. Module électronique selon l'une des revendications 1 à 4, **caractérisé en ce que** le substrat comporte une troisième paire P3 de plages métalliques, la deuxième paire P2 étant située à un premier quart d'onde λt/4 de la première paire P1, la troisième paire P3 étant située à un second quart d'onde λt'/4 de cette première paire P1, permettant d'effectuer respectivement le test à la première fréquence de test Ft et à une deuxième fréquence de test Ft'.

6. Module électronique selon l'une des revendications 3 à 5, **caractérisé en ce que** deux plages métalliques d'au moins une des deux paires sont allongées parallèlement au conducteur électrique de la ligne, permettant d'effecteur un test sur une plage de fréquences de test.

7. Procédé de test électrique d'un module électronique hyperfréquences, le test étant effectué à au moins une fréquence de test Ft, le module électronique comportant :
- un substrat (32) métallisé ayant deux faces principales (44, 48), des conducteurs électriques (46, 50, 66, 68) imprimés sur les faces et parmi ces conducteurs des conducteurs de masse (58, 68) reliés à une masse du module électronique ;
- des composants (12, 20, 22, 34, 36) reportés sur le substrat ;
- au moins une ligne (L, 38) d'interconnexion électrique entre deux composants, la ligne d'interconnexion, d'impédance caractéristique Z0, étant formée par un conducteur électrique (46, 66) et au moins un conducteur de masse (50, 68), le substrat (32) comportant sur la face (44) ayant le conducteur électrique (46) de la ligne (38) d'interconnexion, de part et d'autre de ce conducteur électrique, des plages métalliques (52, 54, 56, 58) reliées aux conducteurs de masse (50), **caractérisé en ce qu'**il comporte au moins les étapes suivantes:
- réalisation d'un court circuit en un premier point de la ligne entre un premier point du conducteur électrique de la ligne et les plages métalliques de masse ;
- application d'une sonde de test (60) d'impédance caractéristique Z0 sur un second point de la ligne entre un second point du conducteur électrique et les plages de masse, ce second point étant distant du court-circuit d'une longueur électrique sensiblement égale au quart d'onde λt/4 de la fréquence de test Ft ;
- application d'un signal hyperfréquence de test, à la fréquence de test Ft, à un accès (86) d'un des composants à tester ;
- prélèvement par la sonde de test du signal de sortie apparaissant sur ce second point de la ligne (38).

8. Procédé de test électrique selon la revendication 7, le module comportant ùn premier (34) et un deuxième (36) circuits intégrés reliés par une ligne (38) d'interconnexion électrique, le substrat du module comportant deux paires P1, P2 de plages métalliques (52, 54, 56, 58), chaque plage métallique d'une paire étant en vis-à-vis l'une de l'autre et de part et d'autre du conducteur électrique (46) de la ligne (38) d'interconnexion, les plages métalliques étant de dimensions, dans le plan du substrat, bien plus petites que la longueur de la ligne d'interconnexion entre les deux circuits intégrés, la première paire P1 étant située du côté du premier circuit intégré 34 et la deuxième paire P2 du côté du deuxième circuit intégré (36) et à une distance électrique de la première paire P1 sensiblement égale au quart d'onde λt/4 de la fréquence de test Ft, **caractérisé en ce que** dans une première phase on effectue le test du premier circuit intégré (34), par la réalisation d'au moins les opérations suivantes :
- mise en court-circuit à la masse de la ligne (38) au niveau de deuxième paire P2 en reliant par une connexion métallique (84) le conducteur électrique (46) et les plages métalliques (56, 58) de la seconde paire P2.
- application de la sonde de test (60) hyperfréquence sur la ligne (38) au niveau de la première paire P1 ;
- injection d'un signal de test St à la fréquence de test Ft, à une entrée (86) du premier circuit intégré (34), à l'aide d'une sonde ;
- retrait de la sonde de test (60) et de la connexion métallique (84) ramenant la ligne (38) et le module dans leur état initial ; et **en ce que** dans une seconde phase on effectue le test du deuxième circuit intégré (36) par la réalisation des opérations suivantes:
- mise en court-circuit à la masse de la ligne (38) au niveau de la première paire P1 en reliant par une connexion métallique (87) le conducteur électrique (46) et les plages métalliques (52, 54) de cette première paire P1.
- application de la sonde de test (60) hyperfréquence sur la ligne (38) au niveau de la deuxième paire P2.
- injection d'un signal de test St à l'entrée (86) du premier circuit intégré (34) à l'aide d'une sonde d'injection.
- retrait de la sonde de test (60) et de la connexion électrique (86) ramenant la ligne (38) et le module dans leur état initial.

9. Procédé de test électrique selon la revendication 8, le substrat du module électronique comportant en outre une troisième paire P3 de plages métalliques, la deuxième paire P2 étant située au premier quart d'onde λt/4 de la première paire P1, la troisième paire P3 étant située à un second quart d'onde λt'/4 de cette première paire P1, **caractérisé en ce que** l'on effectué une première fois la procédure de test à la fréquence Ft en utilisant la première et la deuxième paire et une seconde fois à une autre fréquence Ft' en utilisant la première P1 et la troisième paire P3.
